# EUROPEAN PATENT APPLICATION

(11) **EP 2 966 669 A1**
(43) Date of publication of application: **13.01.2016**
(21) Application number: 14759483.2
(22) Date of filing: 26.02.2014
(51) Int. Cl.: H01L 21/027, G02B 5/02, H01L 51/50, H05B 33/02, H05B 33/10

(54) **METHOD OF MANUFACTURING MEMBER HAVING RELIEF STRUCTURE, AND MEMBER HAVING RELIEF STRUCTURE MANUFACTURED THEREBY**

(30) Priority: 06.03.2013 JP 2013044617
(71) Applicant: JX Nippon Oil & Energy Corporation, Chiyoda-ku Tokyo 100-8162 (JP)
(72) Inventor: TORIYAMA, Shigetaka, Tokyo 100-8162 (JP); TAKAHASHI, Madoka, Tokyo 100-8162 (JP)
(74) Representative: Kuhnen & Wacker
(86) International application number: PCT/JP2014/054599
(87) International publication number: WO 2014/136624

(57) **Abstract**

A method for producing a member having a concave-convex structure includes: a step S1 of preparing a stamp for micro contact printing; a step S2 of preparing a concave-convex forming material; a step S3 of coating convexities of the stamp for micro contact printing with the concave-convex forming material; a step S4 of transferring the concave-convex forming material, which has been applied on the stamp for micro contact printing, onto a substrate; a step S5 of preparing a concave-convex coating material; a step S6 of coating the substrate with the concave-convex coating material; and a curing step S7 of curing the concave-convex forming material and the concave-convex coating material. The member having the concave-convex structure can be produced easily and efficiently.

## Description

### Technical Field

The present invention relates to a method of manufacturing a member having a concave-convex structure (relief structure, concave and convex structure) utilizing a micro-contact printing method.

### Background Art

The lithography method is known as a method for forming a fine pattern (minute pattern) such as a semiconductor integrated circuit. The resolution of a pattern formed by the lithography method depends on the wavelength of a light source, the numerical aperture of an optical system, etc., and a shorter wavelength light source is desired so as to respond to the demand for miniaturized devices in the recent years. Any short wavelength light source is, however, expensive and is not easily developed, and any optical material allowing such short wavelength light to pass therethrough needs to be developed, as well. Further, a large sized optical element is required for producing a pattern with a large area by means of the conventional lithography method, which is difficult both technically and economically. Therefore, a new method for forming a desired pattern having a large area has been considered.

The nano-imprint method is known as a method for forming a fine pattern without using any conventional lithography apparatus. The nano-imprint method is a technology capable of transferring a pattern in nano-meter order by sandwiching a resin between a mold (die) and a substrate. Thus, the nano-imprint method is expected to be practiced not only in the field of semiconductor device but also in many fields such as optical members like organic EL element, LED, etc.; MEMS; biochips; and the like.

As the nanoimprint method using a thermosetting material, a method is known as described, for example, in Patent Literature 1 in which a substrate is coated with a resist film and the resist film is cured by a heater after pressing of the substrate coated with the resist film by use of a flat plate-shaped mold. The nanoimprint molded product using an inorganic sol-gel material, in particular, has high heat resistance, and thus it is suitable for the process including a high temperature treatment. In addition to the pressing method using the flat-plate shaped mold, a roll press method is also known, as described in Patent Literature 2, in which a pressing roll and a cylindrical metal master plate for duplication having a minute concave-convex pattern are used. However, since the metal master plate for duplication is formed through electroforming and the like, and is expensive, therefore mass production of the metal master plate is not easy. On the other hand, as the nanoimprint method utilizing a resin stamp, there is known a micro-contact printing method as described in Patent Literature 3. The resin stamp used in the micro-contact printing method has the advantages of inexpensiveness and easy duplication.

### Citation List

### Patent Literature

PATENT LITERATURE 1: Japanese Patent Application Laid-open No. 2008-049544
PATENT LITERATURE 2: Japanese Patent Application Laid-open No. 2010-269480
PATENT LITERATURE 3: Japanese Patent Application Laid-open No. 2011-005768

### Summary of Invention

### Problem to be Solved by the Invention

An object of the present invention is to provide a novel production method which is capable of mass-producing a member having a fine or minute concave-convex structure efficiently.

### Solution to the Problem

According to a first aspect of the present invention, there is provided a method for producing a member having a concave-convex structure, including:
a step of preparing a stamp having a concave-convex pattern;
a step of coating a convex of the stamp with a concave-convex forming material;
a step of transferring the concave-convex forming material to a substrate by bringing the substrate into contact with the stamp coated with the concave-convex forming material; and
a step of coating the substrate, with a concave-convex coating material so that the concave-convex coating material covers the concave-convex forming material transferred to the substrate.

In the method for producing the member having the concave-convex structure, the substrate may be coated with the concave-convex coating material to form, on the substrate, a concave-convex structure layer made of the concave-convex forming material and the concave-convex coating material.

In the method for producing the member having the concave-convex structure, the concave-convex forming material may be a sol-gel material. The concave-convex coating material may be a sol-gel material. The member having the concave-convex structure may be an optical substrate.

In the method for producing the member having the concave-convex structure, the stamp may be made of silicone rubber.

In the method for producing the member having the concave-convex structure, the concave-convex forming material may have viscosity higher than that of the concave-convex coating material.

In the method for producing the member having the concave-convex structure, the concave-convex forming material may be heated in the step of transferring the concave-convex forming material to the substrate. In this case, the concave-convex forming material may be heated to a temperature in a range of 150 to 200 degrees Celsius.

In the method for producing the member having the concave-convex structure, a height of the concave-convex forming material transferred on the substrate may be adjusted by adjusting solid content concentration of the concave-convex forming material.

In the method for producing the member having the concave-convex structure, a film thickness of the concave-convex coating material, with which the substrate is coated, may be adjusted by adjusting solid content concentration of the concave-convex coating material.

According to a second aspect of the present invention, there is provided a member having a concave-convex structure on a substrate produced by the method for producing the member having the concave-convex structure as defined in the first aspect.

According to a third aspect of the present invention, there is provided a method for producing an organic EL element (organic Electro-Luminescence element or organic light emitting diode), including producing the organic EL element by use of the member having the concave-convex structure as defined in the second aspect.

According to a fourth aspect of the present invention, there is provided an optical member having a concave-convex structure, including: a substrate; an island structure including convexities, which are made of a material different from that of the substrate and are formed on a surface of the substrate to be isolated from one another; and a coating part which covers the island structure and a substrate surface which is exposed between the convexities of the island structure. Both of the convexities and the coating part may be made of a sol-gel material. A material of the convexities may be different from that of the coating part. The optical member is suitably used as a light extraction substrate for organic EL.

### Effect of the Invention

The method for producing the member having the concave-convex structure of the present invention is capable of producing a member having a minute concave-convex structure, such as the optical substrate, easily and efficiently. A concave-convex pattern (concave and convex pattern) of the member produced by the producing method of the present invention may be made of the sol-gel material. In this case, the produced member is excellent in heat resistance, weather resistance (the concept of which includes light resistance), and corrosion resistance. Further, the produced member is also resistant to the producing process of an element in which the produced member is incorporated, and it is possible to extend the service life of the element. Thus, the member having the concave-convex structure obtained by the producing method of the present invention is quite effective for a variety of kinds of devices such as organic EL elements, solar cells, etc., and an organic EL element excellent in the heat resistance, weather resistance and corrosion resistance can be produced by using the member having the concave-convex structure obtained in this manner.

### Brief Description of Drawings

Fig. 1 is a flow chart illustrating a method for producing a member having a concave-convex structure according to the present invention.
Figs. 2(A) to 2(C) schematically depict steps for manufacturing a stamp for micro contact printing, which is used for a method for producing an optical substrate in accordance with an embodiment of the present invention.
Figs. 3(A) to 3(C) schematically depict steps of a transfer process by means of a micro contact printing method.
Fig. 4 conceptually depicts a cross-section structure of the optical substrate, which is produced by the method for producing the optical substrate in accordance with the embodiment of the present invention.
Fig. 5 depicts a cross-section structure of an organic EL element.

### Description of Embodiments

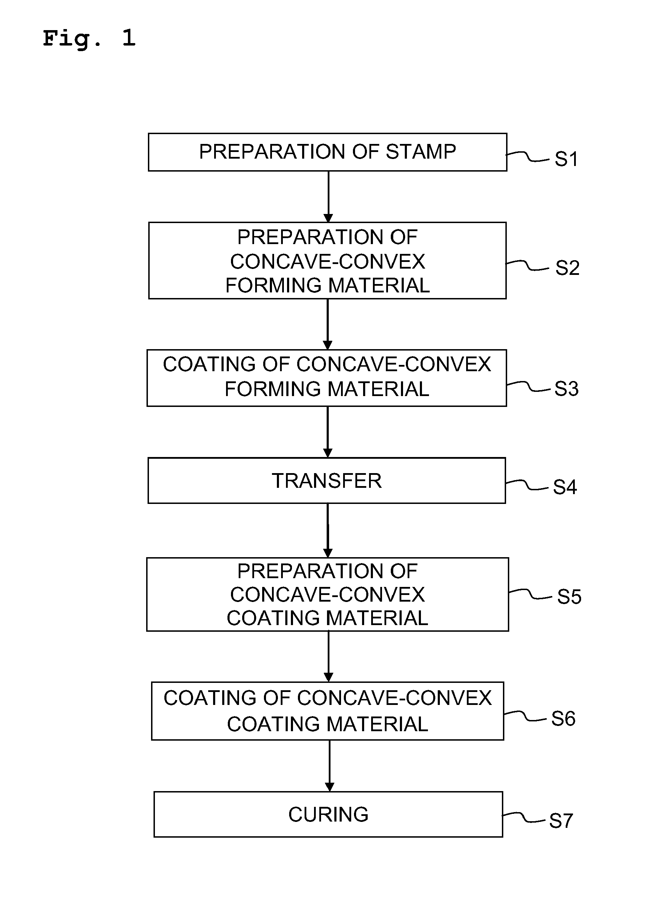

An explanation will be made below with reference to the drawings about an embodiment of a method for manufacturing a member having a concave-convex structure of the present invention. In the following description, a sol-gel material is cited as an example of the material of a concave-convex structure layer to be formed on a substrate. The method for manufacturing the member having the concave-convex pattern or concave-convex structure of the present invention mainly includes, as depicted in Fig. 1, a step S1 of preparing a stamp (mold) for micro contact printing; a step S2 of preparing a concave-convex forming material; a step S3 of coating convexities of the stamp for micro contact printing with the concave-convex forming material; a step S4 of transferring the concave-convex forming material, which has been applied on the stamp for micro contact printing, onto a substrate; a step S5 of preparing a concave-convex coating material; a step S6 of coating the substrate with the concave-convex coating material; and a curing step S7 of curing a concave-convex structure layer which is formed of the concave-convex forming material and the concave-convex coating material. The steps will be explained below sequentially. In the following description, an optical substrate having a wave-like structure is cited as an example of the member having the concave-convex pattern or concave-convex structure.

### [Step of preparing stamp]

In the method for manufacturing the optical substrate in accordance with the embodiment of the present invention, the stamp for micro contact printing is made of an elastically deformable material and has a concave-convex transfer pattern on the surface thereof. The stamp can be manufactured through a method for manufacturing the stamp as described later. A rubber material is preferably used as the elastically deformable material. Silicone rubber or a mixture or copolymer of silicone rubber and any other material is particularly preferably used. Those usable as the silicone rubber include, for example, polyorganosiloxane such as polydimethylsiloxane (PDMS), cross-linking type polyorganosiloxane, a polyorganosiloxane/polycarbonate copolymer, a polyorganosiloxane/polyphenylene copolymer, a polyorganosiloxane/polystyrene copolymer, polytrimethyl-silylpropyne, and poly-4-methyl pentene. The silicone rubber is more inexpensive than other resin materials; has superior heat resistance, high heat conductivity, and elasticity; and is less likely to be deformed under a high temperature condition. Thus, the silicone rubber is suitable for the transfer process for concave-convex pattern under the high temperature condition.

The stamp may have, for example, a length in a range of 50 mm to 1000 mm, a width in a range of 50 mm to 3000 mm, and a thickness in a range of 1 mm to 50 mm. The size of the stamp can be set appropriately based on the size of the optical substrate to be mass-produced. When the thickness of the stamp is less than the lower limit, the strength of the stamp might be insufficient. This could lead to the damage of the stamp during the handling of the stamp. When the thickness of the stamp exceeds the upper limit, it might be difficult to release the stamp from a master mold during the manufacture of stamp. Further, a mold-release treatment may be performed on the surface of the concave-convex pattern of the stamp as needed. The concave-convex pattern may be formed to have an arbitrary shape by an arbitrary method such as a BCP method, a BKL method, and a photolithography method as described later.

The concave-convex pattern of the stamp may be any pattern depending on the usage of the optical substrate as a finally obtained product. For example, the concave-convex pattern may be a micro lens array structure and a structure having the light scattering function, light diffracting function, etc. The concave-convex pattern, for example, may be an irregular concave-convex pattern in which pitches of concavities and convexities are non-uniform and the orientations of the concavities and convexities have no directionality. When the optical substrate is used, for example, for scattering or diffracting visible light, the average pitch of the concavities and convexities can be within a range of 100 nm to 1,500 nm, and more preferably within a range of 200 nm to 1,200 nm. In a similar usage, it is desirable that a first sol-gel liquid is transferred only to portions, of a substrate surface, which correspond to the convexities of the stamp. In such a case, it is preferred that the dimension of the depth of concavities and convexities of the stamp be about 1 to 10 times the dimension of the pitch of the pattern of the stamp. When the depth of concavities and convexities of the stamp is less than the lower limit, the concave-convex forming material is liable to be transferred to parts (portions), on the substrate, to which the concave-convex forming material is not intended to be transferred, in the transfer step by use of the stamp. When the depth of concavities and convexities of the stamp exceeds the upper limit, the following situation could occur. That is, the shape of the stamp is deformed in the transfer step and the transfer pattern of the concave-convex forming material loses its shape, thereby making it impossible to obtain a desired pattern.

Note that the term "average pitch of the concavities and convexities" means an average value of the pitch of concavities and convexities in a case of measuring the pitch of the concavities and convexities (spacing distance between adjacent convex portions or spacing distance between adjacent concave portions) in a surface on which the convexities and concavities are formed. Such an average value of the pitch of concavities and convexities is obtained as follows. Namely, a concavity and convexity analysis image is obtained by measuring the shape of the concavities and convexities on the surface by using a scanning probe microscope (for example, a scanning probe microscope manufactured by Hitachi High-Tech Science Corporation, under the product name of "E-sweep", etc.), under the following measurement conditions, then the distances between randomly selected concave portions or convex portions adjacent to each other are measured at not less than 100 points in the concavity and convexity analysis image, and then the average of the distances is calculated and is determined as the average value of the pitch of concavities and convexities.

The measurement conditions are as follows:
Measurement mode: cantilever intermittent contact mode
Material of the cantilever: silicon
Lever width of the cantilever: 40 µm
Diameter of tip of chip of the cantilever: 10 nm

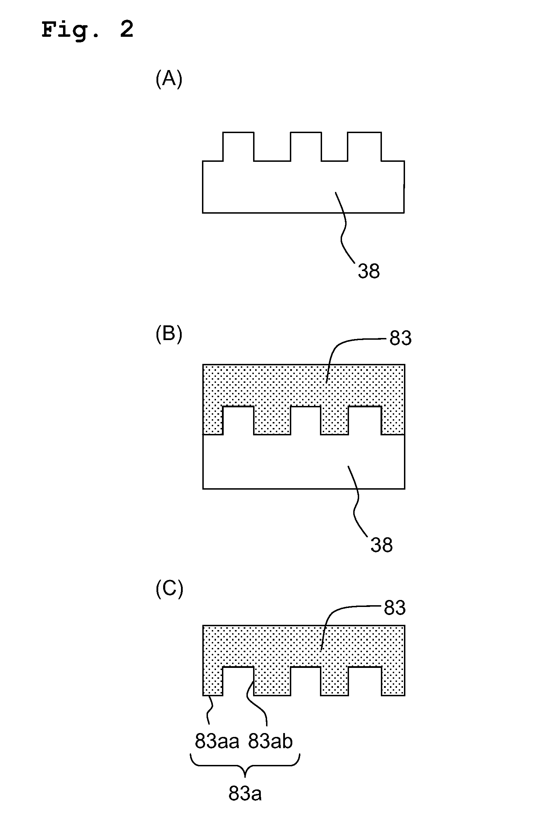

An explanation will be made with reference to Fig. 2 about an exemplary producing method of the stamp for micro contact printing used in the present invention.

A master mold 38 for forming the concave-convex pattern of the stamp is manufactured first. The master mold 38 is made of a quarts substrate, a silicon substrate, or the like. The concave-convex pattern of the master mold 38 can be formed by a method of utilizing the self-organization or self-assembly (micro phase separation) of a block copolymer described in PCT International Application No. PCT/JP2012/050564 (WO2012/096368A1) of the applicants of the present invention (hereinafter referred to as "BCP (Block Copolymer) method" as appropriate), a method of heating and cooling a vapor deposited film on a polymer film to form concavities and convexities of wrinkles on a surface of polymer, as disclosed in International Publication No. WO2011/007878 A1 of the applicants of the present invention (hereinafter referred to as "BKL (Buckling) method" as appropriate), etc. In this case, the master mold 38 having a rectangular cross-sectional structure can be manufactured by forming the concave-convex pattern as a mask on a surface of the quarts substrate, the silicon substrate, or the like by means of the BCP or BKL method, and then etching the substrate in the depth direction of the substrate using the concave-convex pattern as the mask. A general photolithography method may be utilized instead of the BCP and BKL methods. In addition to the above methods, it is possible to manufacture the concave-convex pattern of the master mold 38 by micro fabrication or fine-processing methods including, for example, a cutting (cutting and processing) or machining method, an electron-beam direct imaging method, a particle beam processing method, a scanning probe processing method, and a fine-processing method using the self-organization or self-assembly of fine particles.

When the concave-convex pattern of the master mold 38 is formed by the BCP method, although any material can be used as the material forming the pattern, the material is preferably a block copolymer composed of a combination of two selected from the group consisting of a styrene-based polymer such as polystyren; polyalkyl methacrylate such as polymethyl methacrylate; polyethylene oxide; polybutadiene; polyisoprene; polyvinylpyridine; and polylactic acid.

When the concave-convex pattern of the master mold 38 is formed by the photolithography method, the master mold 38 can be manufactured as follows. That is, an analysis image of the concave-convex pattern manufactured by the BCP or BKL method is obtained by use of a scanning probe microscope; data for an exposure mask is created based on the obtained analysis image; the exposure mask is manufactured by use of the created data through a usual photomask manufacturing process; and exposure and etching are performed on a substrate for the master mold 38 such as the quartz substrate by use of the manufactured exposure mask. The minute concave-convex pattern can be formed over a relative large area by adopting the step-and-repeat-manner or the step-and-scan-manner in which the exposure area of the substrate is successively step-moved relative to the exposure mask during the exposure.

The concave-convex pattern of the master mold 38 may be any pattern depending on the usage of the optical substrate as a finally obtained product. For example, the concave-convex pattern may be a micro lens array structure and a structure having the light scattering function, light diffracting function, etc. The concave-convex pattern may have arbitrary pitch and height. When the pattern is used as the diffraction grating scattering or diffracting light in a visible region, the average pitch of the concavities and convexities is preferably within a range of 100 nm to 1,500 nm, and more preferably within a range of 200 nm to 1,200 nm.

After the master mold 38 is formed by the BCP method, the BKL method, the photolithography method, or the like (Fig. 2(A)), a stamp 83 to which the pattern of the master mold 38 has been transferred is formed as follows. At first, a base resin (main agent), which is the raw material of rubber material, is mixed with a curing agent, and the mixture is stirred or agitated for 10 minutes. This mixture (hereinafter also referred to as "stamp material" as appropriate) may be diluted with a solvent such as toluene. After stirred, the stamp material is subjected to degasification under reduced pressure. Then, the degassed stamp material is applied on the concave-convex pattern of the master mold 38 manufactured in advance (Fig. 2(B)). As the coating method, it is possible to use any coating method such as a cast method, a doctor blade method, or a spin coating method. Subsequently, the stamp material applied on the concave-convex pattern is heated to be cured. The convex-concave pattern of the master mold 38 is transferred and fixed to the stamp material upon the curing of the stamp material. The heating temperature is preferably in a range of room temperature to 50 °C. The heating can be performed by any means including, for example, an oven and a hot plate. The cured stamp material is released or peeled off from the master mold 38, thereby obtaining the stamp 83 for micro contact printing (Fig. 2(C)). The stamp 83 for micro contact printing has the concave-convex pattern formed of convexities 83aa and concavities 83ab. The stamp 83 can be released from the edge or end of the master mold 38.

### <Concave-convex forming material (first sol-gel material) preparation step>

In the method for producing the optical substrate of this embodiment, a first sol-gel material is prepared (step S2 of Fig. 1). The first sol-gel material is used as the concave-convex forming material, which is used for transferring the pattern to a substrate by means of the micro contact printing method. For example, when silica is synthesized on the substrate by the sol-gel method, a sol-gel material of metal alkoxide (silica precursor) is prepared as the first sol-gel material (concave-convex forming material). The silica precursor is exemplified by metal alkoxides including, for example, tetraalkoxide monomers such as tetramethoxysilane (TMOS), tetraethoxysilane (TEOS), tetra-i-propoxysilane, tetra-n-propoxysilane, tetra-i-butoxysilane, tetra-n-butoxysilane, tetra-sec-butoxysilane, and tetra-t-butoxysilane; trialkoxide monomers such as methyl trimethoxysilane, ethyl trimethoxysilane, propyl trimethoxysilane, isopropyl trimethoxysilane, phenyl trimethoxysilane, methyl triethoxysilane (MTES), ethyl triethoxysilane, propyl triethoxysilane, isopropyl triethoxysilane, phenyl triethoxysilane, methyl tripropoxysilane, ethyl tripropoxysilane, propyl tripropoxysilane, isopropyl tripropoxysilane, phenyl tripropoxysilane, methyl triisopropoxysilane, ethyl triisopropoxysilane, propyl triisopropoxysilane, isopropyl triisopropoxysilane, and phenyl triisopropoxysilane; dialkoxide monomers such as dimethyl dimethoxysilane, dimethyl diethoxysilane, dimethyl dipropoxysilane, dimethyl diisopropoxysilane, dimethyl di-n-butoxysilane, dimethyl di-i-butoxysilane, dimethyl di-sec-butoxysilane, dimethyl di-t-butoxysilane, diethyl dimethoxysilane, diethyl diethoxysilane, diethyl dipropoxysilane, diethyl diisopropoxysilane, diethyl di-n-butoxysilane, diethyl di-i-butoxysilane, diethyl di-sec-butoxysilane, dipropyl di-t-butoxysilane, dipropyl dimethoxysilane, dipropyl diethoxysilane, dipropyl dipropoxysilane, dipropyl diisopropoxysilane, dipropyl di-n-butoxysilane, dipropyl di-i-butoxysilane, dipropyl di-sec-butoxysilane, dipropyl di-t-butoxysilane, diisopropyl dimethoxysilane, diisopropyl diethoxysilane, diisopropyl dipropoxysilane, diisopropyl diisopropoxysilane, diisopropyl di-n-butoxysilane, diisopropyl di-i-butoxysilane, diisopropyl di-sec-butoxysilane, diisopropyl di-t-butoxysilane, diphenyl dimethoxysilane, diphenyl diethoxysilane, diphenyl dipropoxysilane, diphenyl diisopropoxysilane, diphenyl di-n-butoxysilane, diphenyl di-i-butoxysilane, diphenyl di-sec-butoxysilane, and diphenyl di-t-butoxysilane; a polymer obtained by polymerizing the above monomers in small amounts; and a composite material characterized in that a functional group and/or a polymer is/are introduced into a part of the above material. Further, the silica precursor is exemplified, for example, by metal acetylacetonate, metal carboxylate, oxychloride, chloride, and mixtures thereof. However, the silica precursor is not limited to these. Moreover, examples of the metal species other than Si include Ti, Sn, Al, Zn, Zr, In and mixtures thereof, but the examples of the metal species are not limited to these. It is also possible to use any appropriate mixture of precursors of the oxides of the above metals.

When a mixture of TEOS and MTES is used, the mixture ratio thereof can be, for example, 1:1 in a molar ratio. The sol-gel material produces amorphous silica by being subjected to the hydrolysis and polycondensation reaction. An acid such as hydrochloric acid or an alkali such as ammonia is added in order to adjust the pH of the solution as a synthesis condition. The pH is preferably not more than 4 or not less than 10. Water may be added to perform the hydrolysis. The amount of water to be added can be not less than 1.5 times, with respect to the amount of metal alkoxide species, in the molar ratio. A material other than the silica can be formed on the substrate by means of the sol-gel method. For example, a titanium-based material, a material based on indium tin oxide (ITO), AlO₃, ZrO₂, ZnO, etc. may be used.

Examples of the solvent of the first sol-gel material include alcohols such as methanol, ethanol, isopropyl alcohol (IPA), and butanol; aliphatic hydrocarbons such as hexane, heptane, octane, decane, and cyclohexane; aromatic hydrocarbons such as benzene, toluene, xylene, and mesitylene; ethers such as diethyl ether, tetrahydrofuran, and dioxane; ketones such as acetone, methyl ethyl ketone, isophorone, and cyclohexanone; ether alcohols such as butoxyethyl ether, hexyloxyethyl alcohol, methoxy-2-propanol, and benzyloxyethanol; glycols such as ethylene glycol and propylene glycol; glycol ethers such as ethylene glycol dimethyl ether, diethylene glycol dimethyl ether, and propylene glycol monomethyl ether acetate; esters such as ethyl acetate, ethyl lactate, and γ-butyrolactone; phenols such as phenol and chlorophenol; amides such as N,N-dimethylformamide, N,N-dimethylacetamide, and N-methylpyrrolidone; halogen-containing solvents such as chloroform, methylene chloride, tetrachloroethane, monochlorobenzene, and dichlorobenzene; hetero-element containing compounds such as carbon disulfide; water; and mixture solvents thereof. Especially, ethanol and isopropyl alcohol are preferable. Further, a mixture of water and ethanol, and a mixture of water and isopropyl alcohol are also preferable.

As an additive of the first sol-gel material, it is possible to use polyethylene glycol, polyethylene oxide, hydroxypropylcellulose, and polyvinyl alcohol for viscosity adjustment; alkanolamine such as triethanolamine, β-diketone such as acetylacetone, β-ketoester, formamid, dimetylformamide, and dioxane, etc., as a solution stabilizer. The first so-gel material needs to have relatively high viscosity, which is such an extent that the first sol-gel material can keep the size of each convex of the stamp (such an extent that the first sol-gel material does not spread beyond the size of each convex of the stamp) during the pattern transfer in which the first sol-gel material applied on the stamp for micro contact printing is brought into contact with the substrate. It is preferred that the first sol-gel material have a viscosity in a range of 0.01 Pa·s to 100 Pa·s. The viscosity of the first sol-gel material can be adjusted depending on the solid content concentration and/or the kind of solvent, instead of or in addition to the use of the additive.

As the first sol-gel material, it is allowable to use a photo-curable sol-gel material, rather than the sol-gel material which is cured by being heated. In such a case, it is possible to adopt, for example, a method in which photo-acid generator such as hexafluorophosphate aromatic sulfonium salt which generates acid by light is used, or a method in which chemical modification (chelation) is caused by adding β-diketone represented by acetylacetone to a sol and the chemical modification is removed by being irradiated with light.

When the substrate (member) to be manufactured is used for a purpose which does not require excellent heat resistance, it is possible to use, as the concave-convex forming material, a resin material, instead of the sol-gel material. The curable resin can be exemplified, by resins such as photocurable resins, thermosetting resins, moisture curing type resins, and chemical curing type resins (two-liquid mixing type resins), etc. Specifically, the curable resin can be exemplified, by various resins including, for example, monomers, oligomers, and polymers of those based on epoxy, acrylic, methacrylic, vinyl ether, oxetane, urethane, melamine, urea, polyester, polyolefin, phenol, cross-linking type liquid crystal, fluorine, silicone, and polyamide, etc. Further, it is allowable to use that obtained by mixing an inorganic material or a curable resin material with an ultraviolet absorbent material. The ultraviolet absorbent material has the function or effect to prevent the deterioration of the film by absorbing ultraviolet rays and converting light energy into something harmless such as heat. Any known agent may be used as the ultraviolet absorbent material. Those usable as the ultraviolet absorbent material include, for example, benzotriazole-based absorbents, triazine-based absorbents, salicylic acid derivative-based absorbents, and benzophenone-based absorbents.

### <Concave-convex forming material (first sol-gel material) coating step>

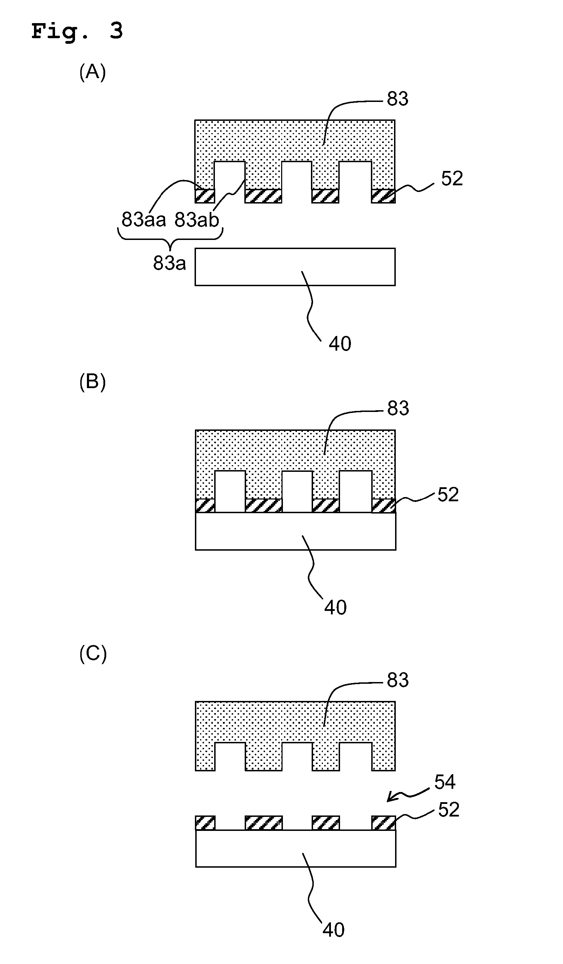

The convexities of the stamp for micro contact printing are coated with the first sol-gel material (concave-convex forming material) prepared as described above (S3 of Fig. 1). For example, as depicted in Fig. 3(A), a coating film 52 made of the first sol-gel material (concave-convex forming material) is formed on each convexity (convex portion) 83aa of concave-convex pattern 83a of the stamp 83. It is preferred that only the surface (surface facing a transfer-target object (the transfer-target object is the substrate 40 in this embodiment)) of each convexity 83aa of the stamp 83 be coated with the first sol-gel material. The first sol-gel material, however, is liable to spread over lateral parts of each convexity 83aa depending on the coating method (i.e., the first sol-gel material may spread over each concave 83ab). Such a case, in which the first so-gel material adheres to the concavities 83ab of the stamp 83, is acceptable, provided that the pattern of each convexity 83aa of the stamp 83 can be transferred to the substrate during the transfer step as described later. As for the coating method, it is possible to use any coating method including, for example, a bar coating method, a spin coating method, a spray coating method, a dip coating method, a die coating method, and an ink-jet method. In view of the fact that the stamp having a relatively large areal size can be coated uniformly with the sol-gel material and that the coating can be completed quickly before the first sol-gel material cures (forms a gel), the bar coating method, the die coating method, and the spin coating method are preferably used. Alternatively, the convexities of the stamp can be coated with the sol-gel material by forming the stamp to have a roll shape; immersing the rolled stamp in a small amount of sol-gel material in a container; and rotating the stamp in the container. The rolled stamp can be manufactured, for example, by winding or rolling up the stamp around a hard roll such as metallic roll. The film thickness of the coating film of the first sol-gel material on the convexities of the stamp is preferably in a range of 300 nm to 10,000 nm. The film thickness of the coating film of the first sol-gel material can be adjusted, for example, by the viscosity of the first sol-gel material. Further, a hydrophobization treatment may be performed on the surface of the coating film of the first sol-gel material. Any known method for the hydrophobic treatment may be used. For example, regarding the surface of silica, the hydrophobic treatment can be performed with dimethyl dichlorosilane, trimethyl alkoxysilan, etc., or with a silicone oil and a trimethylsilylating agent such as hexamethyl-disilazane. Alternatively, it is also allowable to employ a surface treatment method for a surface of metal oxide powder with supercritical carbon dioxide.

### <Transfer step>

After the coating step, the pattern of the stamp 83 is transferred to the substrate 40 by the micro contact printing method (step S4 of Fig. 1). For example, as depicted in Fig. 3(A), the substrate 40 is disposed immediately below the stamp 83 having the coating film 52 made of the first sol-gel material. Next, as depicted in Fig. 3(B), the substrate 40 is brought in contact with the coating film 52, which is made of the first sol-gel material and is formed on the convexities 83aa of the stamp 83. As the substrate 40, it is allowable to use substrates made of inorganic materials such as glass, silica glass, and silicon substrates, or substrates of resins such as polyethylene terephthalate (PET), polyethylene naphthalate (PEN), polycarbonate (PC), cycloolefin polymer (COP), polymethyl methacrylate (PMMA), polystyrene (PS), polyimide (PI), and polyarylate. The substrate made of glass is preferably used owing to the fact that the glass substrate has great adhesive force to the sol-gel material. The great adhesive force between the substrate 40 and the sol-gel material allows the pattern of the stamp 83 to be precisely transferred to the substrate 40. Further, a hydrophilization treatment may be performed on the surface of the substrate 40 through an O₃ treatment or the like. The hydrophilization treatment performed on the surface of the substrate 40 further increases the adhesive force between the substrate 40 and the sol-gel material. The substrate 40 may be transparent (light transmissive) or opaque. If a substrate having the concave-convex pattern obtained from this substrate 40 is used for production of the organic EL element as described later, this substrate 40 desirably has the heat resistance, the light resistance against ultraviolet (UV) light, and the like. In these respects, substrates composed of inorganic materials such as glass, silica glass, and silicon substrates are more preferable. It is allowable to perform a surface treatment for the substrate 40 or to provide an easy-adhesion layer on the substrate 40 in order to improve the adhesion property, and allowable to provide a gas barrier layer in order to keep out moisture and/or gas such as oxygen.

After that, as depicted in Fig, 3(C), the stamp 83 is separated from the substrate 40 to release or peel off the stamp 83 from the substrate 40 (Fig. 3(C)). This allows the coating film 52, which is made of the first sol-gel material and is formed on each convexity 83aa of the stamp 83, to be transferred on the substrate 40, so that an island structure 54 is formed on the substrate 40. The island structure 54 includes portions (convexities) which are made of the first sol-gel material and are dotting the substrate 40 in a state that each of the portions (convexities) corresponds to the pattern of each convexity 83aa of the stamp 83. The "island structure" in the present invention means the assembly, group or set of structures (or convexities), which protrude from the substrate 40 in a state of being isolated from one another or being separated from one another. Each of the structures has a bottom surface having a predetermined areal size, and the bottom surface of each of the structures is brought into contact with the surface of the substrate 40. Each of the structures has a cross-section perpendicular to the surface of the substrate 40, and the cross-section (cross-sectional shape) may have various shapes including, for example, rectangles such as trapezoidal shapes, mountain-like shapes (chevron shapes, triangles), and semicircles. The structures of the present invention, however, do not include any structure making a point-to-point contact with the surface of the substrate, like spheres (which have circular cross-sections perpendicular to the surface of the substrate). Since the structures (or convexities) of the island structure 54 are on the substrate 40 in a state of being isolated from one another at predetermined intervals, parts, of the substrate surface, between the structures are exposed. The height of convexities of the island structure 54 which are made of the first sol-gel material (concave-convex forming material) is preferably in a range of 300 nm to 10,000 nm. The height of convexities of the island structure 54 can be adjusted, for example, by adjusting the film thickness of the coating film 52 made of the first sol-gel material. When the rolled stamp described above is utilized, all that is required for transferring the first sol-gel material to the substrate 40 and releasing the stamp from the substrate 40 is to allow the rolled stamp coated with the first so-gel material to roll on the substrate 40.

The coating film 52 may be heated when the coating film 52 made of the first sol-gel material is being brought in contact with the substrate 40. Heating promotes the chemical reaction of the sol-gel material in the coating film 52 and the evaporation of the solvent and water generated by the chemical reaction. This facilitates the curing of the coating film 52 and the following situations can be prevented. That is, the coating film 52 which is not yet cured is transferred to the substrate 40 in a state of spreading beyond each convexity 83aa of the stamp 83, and the coating film 52 which is not yet cured remains on each convexity 83aa of the stamp 83 after the transfer. When the pattern transfer is performed through the micro contact printing by reusing the stamp 83, the coating film 52 remained on each convexity 83aa of the stamp 83 might change the film thickness of the first sol-gel material on the stamp 83, or cause particles such as dust by being cured thereon. As the method for heating the coating film 52, for example, the heating through the stamp 83 may be performed, or the coating film 52 may be heated directly or from the side of the substrate 40. The heating may be performed with any heating means. For example, when the coating film 52 is heated from the side of the substrate 40, the heating may be performed with a hot plate provided on the side of the back surface of the substrate 40. Although the heating temperature of the coating film 52 depends on the speed of processing of the substrate 40, the higher the heating temperature is, the more preferable. A temperature close to the upper temperature limit of the stamp 83 is preferred. For example, when the stamp 83 is made of polydimethylsiloxane (PDMS), the heating temperature of the coating film 52 made of the first sol-gel material is preferably in a range of 150 to 200 degrees Celsius. When the photo-curable sol-gel material is used as the first sol-gel material, the gelation (curing) of the first sol-gel material may be facilitated by irradiation with energy rays such as ultraviolet rays and excimer instead of the heating of the coating film 52.

### <Concave-convex coating material (second sol-gel material) preparation step>

In the method for manufacturing the optical substrate of this embodiment, a second sol-gel material is prepared (step S5 of Fig. 1). The second sol-gel material is used as the concave-convex coating material, which is applied on the substrate formed with the island structure made of the first sol-gel material. For example, when silica is synthesized on the substrate by the sol-gel method, a sol-gel material of metal alkoxide (silica precursor) is prepared as the second sol-gel material (concave-convex coating material) in a similar manner to the first sol-gel material. The silica precursor is exemplified, similar to the first sol-gel material, by metal alkoxides including, for example, tetraalkoxide monomers such as tetramethoxysilane (TMOS), tetraethoxysilane (TEOS), tetra-i-propoxysilane, tetra-n-propoxysilane, tetra-i-butoxysilane, tetra-n-butoxysilane, tetra-sec-butoxysilane, and tetra-t-butoxysilane; trialkoxide monomers such as methyl trimethoxysilane, ethyl trimethoxysilane, propyl trimethoxysilane, isopropyl trimethoxysilane, phenyl trimethoxysilane, methyl triethoxysilane (MTES), ethyl triethoxysilane, propyl triethoxysilane, isopropyl triethoxysilane, phenyl triethoxysilane, methyl tripropoxysilane, ethyl tripropoxysilane, propyl tripropoxysilane, isopropyl tripropoxysilane, phenyl tripropoxysilane, methyl triisopropoxysilane, ethyl triisopropoxysilane, propyl triisopropoxysilane, isopropyl triisopropoxysilane, and phenyl triisopropoxysilane; dialkoxide monomers such as dimethyl dimethoxysilane, dimethyl diethoxysilane, dimethyl dipropoxysilane, dimethyl diisopropoxysilane, dimethyl di-n-butoxysilane, dimethyl di-i-butoxysilane, dimethyl di-sec-butoxysilane, dimethyl di-t-butoxysilane, diethyl dimethoxysilane, diethyl diethoxysilane, diethyl dipropoxysilane, diethyl diisopropoxysilane, diethyl di-n-butoxysilane, diethyl di-i-butoxysilane, diethyl di-sec-butoxysilane, dipropyl di-t-butoxysilane, dipropyl dimethoxysilane, dipropyl diethoxysilane, dipropyl dipropoxysilane, dipropyl diisopropoxysilane, dipropyl di-n-butoxysilane, dipropyl di-i-butoxysilane, dipropyl di-sec-butoxysilane, dipropyl di-t-butoxysilane, diisopropyl dimethoxysilane, diisopropyl diethoxysilane, diisopropyl dipropoxysilane, diisopropyl diisopropoxysilane, diisopropyl di-n-butoxysilane, diisopropyl di-i-butoxysilane, diisopropyl di-sec-butoxysilane, diisopropyl di-t-butoxysilane, diphenyl dimethoxysilane, diphenyl diethoxysilane, diphenyl dipropoxysilane, diphenyl diisopropoxysilane, diphenyl di-n-butoxysilane, diphenyl di-i-butoxysilane, diphenyl di-sec-butoxysilane, and diphenyl di-t-butoxysilane; a polymer obtained by polymerizing the above monomers in small amounts; and a composite material characterized in that a functional group and/or a polymer is/are introduced into a part of the above material. Further, the silica precursor is exemplified, for example, by metal acetylacetonate, metal carboxylate, oxychloride, chloride, and mixtures thereof. However, the silica precursor is not limited to these. Moreover, examples of the metal species other than Si include Ti, Sn, Al, Zn, Zr, In and mixtures thereof, but the examples of the metal species are not limited to these. It is also possible to use any appropriate mixture of precursors of the oxides of the above metals.

When a mixture of TEOS and MTES is used, the mixture ratio thereof can be, for example, 1:1 in a molar ratio. The sol-gel material produces amorphous silica by being subjected to the hydrolysis and polycondensation reaction. An acid such as hydrochloric acid or an alkali such as ammonia is added in order to adjust the pH of the solution as a synthesis condition. The pH is preferably not more than 4 or not less than 10. Water may be added to perform the hydrolysis. The amount of water to be added can be not less than 1.5 times, with respect to the amount of metal alkoxide species, in the molar ratio. A material other than the silica can be formed on the substrate by means of the sol-gel method. For example, a titanium-based material, a material based on indium tin oxide (ITO), Al₂O₃, ZrO₂, ZnO, etc. may be used. In a case that the optical substrate obtained in this embodiment is to be used as the substrate for light extraction of the organic EL element, it is preferred that the second sol-gel material be made of the same material as the first sol-gel material because the difference between the refractive index of the first sol-gel material and the refractive index of the second sol-gel material could cause such a situation that light is totally reflected by the interface between the layer made of the first sol-gel material and the layer made of the second sol-gel material of the optical substrate to reduce the light extraction effect.

Examples of the solvent of the second sol-gel material include, similar to the first sol-gel material, alcohols such as methanol, ethanol, isopropyl alcohol (IPA), and butanol; aliphatic hydrocarbons such as hexane, heptane, octane, decane, and cyclohexane; aromatic hydrocarbons such as benzene, toluene, xylene, and mesitylene; ethers such as diethyl ether, tetrahydrofuran, and dioxane; ketones such as acetone, methyl ethyl ketone, isophorone, and cyclohexanone; ether alcohols such as butoxyethyl ether, hexyloxyethyl alcohol, methoxy-2-propanol, and benzyloxyethanol; glycols such as ethylene glycol and propylene glycol; glycol ethers such as ethylene glycol dimethyl ether, diethylene glycol dimethyl ether, and propylene glycol monomethyl ether acetate; esters such as ethyl acetate, ethyl lactate, and γ-butyrolactone; phenols such as phenol and chlorophenol; amides such as N,N-dimethylformamide, N,N-dimethylacetamide, and N-methylpyrrolidone; halogen-containing solvents such as chloroform, methylene chloride, tetrachloroethane, monochlorobenzene, and dichlorobenzene; hetero-element containing compounds such as carbon disulfide; water; and mixture solvents thereof. Especially, ethanol and isopropyl alcohol are preferable. Further, a mixture of water and ethanol, and a mixture of water and isopropyl alcohol are also preferable.

As an additive of the second sol-gel material, similar to the first sol-gel material, it is possible to use polyethylene glycol, polyethylene oxide, hydroxypropylcellulose, and polyvinyl alcohol for viscosity adjustment; alkanolamine such as triethanolamine, β-diketone such as acetylacetone, β-ketoester, formamid, dimetylformamide, dioxane, etc., as a solution stabilizer. The second sol-gel material needs to have low viscosity, which is such an extent that the second sol-gel material can spread over the substrate when applied on the substrate through the spin coating or the like. Therefore, it is preferred that the viscosity of the second sol-gel material be in a range of 0.001 Pa ·s to 10 Pa s. The viscosity of the second sol-gel material can be adjusted depending on the solid content concentration and/or the kind of solvent. In terms of the above reason and workability in the coating process, it is preferred that the viscosity of the second sol-gel material be lower than that of the first sol-gel material.

Instead of using the sol-gel material which is cured by being heated, it is allowable to use a photo-curable sol-gel material as the second sol-gel material. In such a case, similar to the first sol-gel material, it is possible to adopt, for example, a method in which photo-acid generator such as hexafluorophosphate aromatic sulfonium salt which generates acid by light is used, or a method in which chemical modification (chelation) is caused by adding β-diketone represented by acetylacetone to a sol and the chemical modification is removed by irradiation with energy rays such as ultraviolet rays and excimer.

The concave-convex coating material may be composed of inorganic materials such as TiO₂, ZnO, ZnS, ZrO, BaTiO₃, and SrTiO₂. Of the above materials, TiO₂ is preferably used in view of the film formation performance (coating property) and the refractive index.

The curable resin material may be used as the concave-convex coating material. As the curable resin, it is possible to use, for example, similar to the concave-convex forming material, resins such as photocurable resins, thermosetting resins, moisture curing type resins, and chemical curing type resins (two-liquid mixing type resins). Specifically, the curable resin can be exemplified, for example, by various resins including, for example, monomers, oligomers, and polymers of those based on epoxy, acrylic, methacrylic, vinyl ether, oxetane, urethane, melamine, urea, polyester, polyolefin, phenol, cross-linking type liquid crystal, fluorine, silicone, and polyamide.

A silane coupling agent may be used as the concave-convex coating material. When the organic EL element is produced by using the optical substrate 100 of the embodiment, the use of the silane coupling agent can improve the adhesion property between a concave-convex structure layer, which will be described later, and a layer, such as an electrode, to be formed on the concave-convex structure layer. This develops the resistance in the cleaning step and the high temperature treatment step included in the production process of the organic EL element. The type of silane coupling agent used for the coating layer is not especially limited. As the silane coupling agent, it is possible to use, for example, an organic compound represented by RSiX₃ (R is an organic functional group containing at least one selected from a vinyl group, a glycidoxy group, an acryl group, a methacryl group, an amino group, and a mercapto group, and X is a halogen element or an alkoxyl group). As the method for applying the silane coupling agent, it is possible to employ various coating methods including, for example, a spin coating method, a spray coating method, a dip coating method, a dropping method, a gravure printing method, a screen printing method, a relief printing method, a die coating method, a curtain coating method, an ink-jet method, and a sputtering method. Then, the concave-convex coating material is dried under a proper condition depending on the material used, thereby the cured film can be obtained. For example, the concave-convex coating material may be heat-dried at temperatures of 100 to 150 degrees Celsius for 15 to 90 minutes.

The concave-convex coating material may be that obtained by mixing an inorganic material or a curable resin material with an ultraviolet absorbent material. The ultraviolet absorbent material has the function or effect to prevent the deterioration of the film by absorbing ultraviolet rays and converting light energy into something harmless such as heat. Any known agent may be used as the ultraviolet absorbent material. Those usable as the ultraviolet absorbent material include, for example, benzotriazole-based absorbents, triazine-based absorbents, salicylic acid derivative-based absorbents, and benzophenone-based absorbents.

A polysilazane solution may be used as the concave-convex coating material. In this case, the film made of silica may be obtained by forming the coating film, which is formed by applying the polysilazane solution, into ceramic (silica reforming or modification). It is noted that "polysilazane" is a polymer having a silicon-nitrogen bond, is an inorganic polymer comprising Si-N, Si-H, N-H, or the like, and is a precursor of a ceramics such as SiO₂, Si₃N₄, or SiOₓN_{y}, which is an intermediate solid solution of them. A compound, which is ceramized at relatively low temperature, and is modified into silica, is more preferred. For example, a compound, which is represented by the following formula (1) described in Japanese Patent Application Laid-open No. H8-112879, is more preferable.

Formula (1): -Si (R1) (R2)-N (R3)-

In the formula (1), R1, R2, and R3 each represent a hydrogen atom, an alkyl group, an alkenyl group, a cycloalkyl group, an aryl group, an alkylsilyl group, an alkylamino group, or an alkoxy group.

Of the compounds represented by the formula (1), perhydropolysilazane (referred to also as PHPS) in which all of R1, R2, and R3 are hydrogen atoms and organopolysilazane in which a part of the hydrogen bonded to Si thereof is substituted by, for example, an alkyl group are particularly preferred.

Other examples of the polysilazane ceramized at low temperature include: silicon alkoxide-added polysilazane obtained by reacting polysilazane with silicon alkoxide (for example, Japanese Patent Laid-Open No. 5-238827); glycidol-added polysilazane obtained by reaction with glycidol (for example, Japanese Patent Laid-open No. 6-122852); alcohol-added polysilazane obtained by reaction with alcohol (for example, Japanese Patent Laid-open No. 6-240208); metal carboxylate-added polysilazane obtained by reaction with metal carboxylate (for example, Japanese Patent Laid-Open No. 6-299118); acetylacetonato complex-added polysilazane obtained by reaction with an acetylacetonato complex containing a metal (for example, Japanese Patent Laid-Open No. 6-306329); metallic fine particles-added polysilazane obtained by adding metallic fine particles (for example, Japanese Patent Laid-Open No. 7-196986), and the like.

As the solvent of the polysilazane solution, it is possible to use hydrocarbon solvents such as aliphatic hydrocarbons, alicyclic hydrocarbons, and aromatic hydrocarbons; halogenated hydrocarbon solvents; and ethers such as aliphatic ethers and alicyclic ethers. Amine or a metal catalyst may be added in order to promote the modification into a silicon oxide compound.

The concave-convex forming material and the concave-convex coating material may be composed of the same material, or may be composed of different materials. For example, both of the concave-convex forming material and the concave-convex coating material may be composed of the sol-gel material; the concave-convex forming material may be composed of the sol-gel material and the concave-convex coating material may be composed of a material other than the sol-gel material; or the concave-convex forming material may be composed of a material other than the sol-gel material and the concave-convex coating material may be composed of the sol-gel material. Alternatively, the concave-convex forming material may be composed of a resin material and the concave-convex coating material may be composed of polysilazane. When the concave-convex forming material and the concave-convex coating material are composed of the same or similar material(s), they may be stacked to have different compositions and densities.

### <Concave-convex coating material (second sol-gel material) coating step >

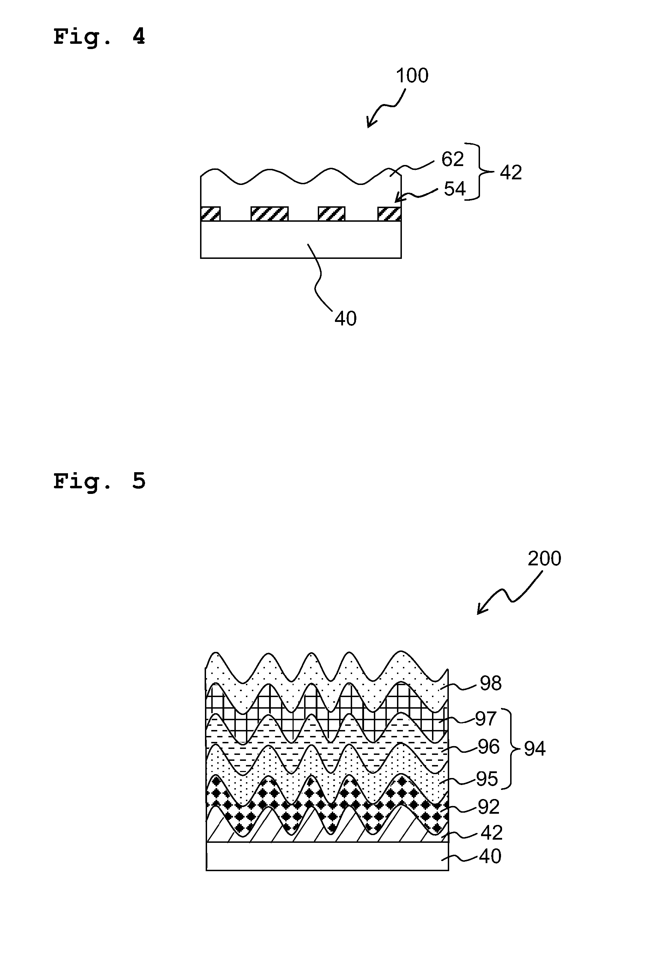

The substrate 40, on which the island structure 54 made of the first sol-gel material is formed, is coated with the second sol-gel material (concave-convex coating material) prepared as described above (step S6 of Fig. 1). Thus, as depicted in Fig. 4, a coating film 62 made of the second sol-gel material (concave-convex coating material) is formed to cover the island structure 54 made of the first sol-gel material. In this situation, a part of the second sol-gel material, which is not directly covering the island structure 54, covers an exposed part of the substrate 40 to make contact with the substrate 40. A sol-gel material layer (concave-convex structure layer) 42 is formed of the island structure 54 made of the first sol-gel material and the coating film 62 made of the second sol-gel material. The sol-gel material layer 42 may form a wave-like structure (concave-convex structure) having convexities, which correspond to portions of the convexities of the island structure 54 made of the first sol-gel material. In a case that the manufactured optical substrate is used for the production of the organic EL element and that an organic layer is vapor-deposited on the surface of the concave-convex pattern, the concave-convex pattern formed to have a smooth wave-like structure can reliably prevent such a situation that a part of the organic layer is extremely thin. That is, the organic layer can be deposited to have a very uniform film thickness. As a result, the distance between electrodes is allowed to be uniform, thereby making it possible to prevent the concentration of the electric field. Further, the organic EL element can have a gentle gradient of the potential distribution in inclined portions of the wave-like form of the concave-convex structure, and thus the occurrence of leak current can be prevented further.

The film thickness of the coating film 62 made of the second sol-gel material is needed to be adjusted depending on the concave-convex shape required for the optical substrate. For example, when the optical substrate as a finally obtained product is required to have the wave-like structure having a depth of 500 nm, the coating film 62 made of the second sol-gel material may have a film thickness which is thinner, by 500 nm, than the height of the island structure 54 made of the first sol-gel material. The film thickness of the coating film 62 can be adjusted depending on, for example, the solid content concentration of the second sol-gel material.

The concave-convex pattern of the sol-gel material layer (concave-convex structure layer) 42 may be formed to have any pattern, such as a micro lens array structure and a structure having the light scattering function, light diffracting function, etc., depending on the usage of the optical substrate as a finally obtained product. The pitches and heights of the concave-convex pattern are arbitrary. However, for example, when the pattern is used as the diffraction grating scattering or diffracting light in a visible region, the average pitch of the concavities and convexities is preferably in a range of 100 to 1,500 nm, more preferably in a range of 200 to 1,200 nm. When the average pitch of the concavities and convexities is less than the lower limit, the pitches are so small relative to wavelengths of the visible light that the diffraction of the light by the concavities and convexities is less likely to occur. When the average pitch exceeds the upper limit, the diffraction angle is so small that functions as an optical element such as the diffraction grating are more likely to be lost. The average value of the depth distribution of the concavities and convexities is preferably in a range of 20 to 200 nm, and more preferably in a range of 30 to 150 nm. The standard deviation of the depth of convexities and concavities is preferably within a range of 10 to 100 nm, and more preferably within a range of 15 to 75 nm. It is allowable to perform the hydrophobic treatment for the surface of the sol-gel material layer. Any known method for the hydrophobic treatment may be used. For example, regarding the surface of silica, the hydrophobic treatment can be performed with dimethyl dichlorosilane, trimethyl alkoxysilan, etc., or with a silicone oil and a trimethylsilylating agent such as hexamethyl-disilazane. Alternatively, it is allowable to employ a surface treatment method for a surface of metal oxide powder with supercritical carbon dioxide. It is allowable to provide a gas barrier layer on the sol-gel material layer in order to keep out moisture and/or gas such as oxygen.

In the present application, the average value of the depth distribution of concavities and convexities and the standard deviation of the depth of concavities and convexities, of the sol-gel material layer 42 of the optical substrate as a finally obtained product, can be calculated by the following manner. Namely, a concavity and convexity analysis image is obtained by measuring the shape of the concavities and convexities on the surface by using a scanning probe microscope (for example, a scanning probe microscope manufactured by Hitachi High-Tech Science Corporation, under the product name of "E-sweep", etc.), in a randomly selected measurement region of 3µm square to 10 µm square (length: 3 µm to 10 µm, width 3 µm to 10 µm) under the above-described condition. When doing so, data of height of concavities and convexities at not less than 16,384 points (vertical: 128 points x horizontal: 128 points) are obtained within the measurement region, each in nanometer scale. Note that although the number of measurement points is different depending on the kind and setting of the measuring device which is used, for example in a case of using the above-described scanning probe microscope manufactured by Hitachi High-Tech Science Corporation, under the product name of "E-sweep", it is possible to perform the measurement at measurement points of 65,536 points (vertical: 256 points x horizontal: 256 points; namely, the measurement in a resolution of 256 x 256 pixels) within the measurement region of 3 µm square. With respect to the height of concavities and convexities (unit: nm) measured in such a manner, at first, a measurement point "P" is determined, among all the measurement points, which is the highest from the surface of a transparent support substrate. Then, a plane which includes the measurement point P and which is parallel to the surface of the transparent support substrate is determined as a reference plane (horizontal plane), and a depth value from the reference plane (difference obtained by subtracting, from the value of height from the transparent support substrate at the measurement point P, the height from the transparent support substrate at each of the measurement points) is obtained as the data of depth of concavities and convexities. Note that such a depth data of the concavities and convexities can be obtained, for example, by performing automatic calculation with software in the measurement device (for example, the above-described scanning probe microscope manufactured by Hitachi High-Tech Science Corporation, under the product name of "E-sweep"), and the value obtained by the automatic calculation in such a manner can be utilized as the data of depth of concavities and convexities. After obtaining the data of depth of concavity and convexity at each of the measurement points in this manner, the values, which can be calculated by obtaining the arithmetic average value and the standard deviation of the obtained data of depth of concavity and convexity, are adopted as the average value of the depth distribution of concavities and convexities and the standard deviation of the depth of concavities and convexities. In this specification, the average pitch of concavities and convexities, the average value of the depth distribution of concavities and convexities, and the standard deviation of the depth of convexities and concavities can be obtained via the above-described measuring method, regardless of the material of the surface formed to have the concavities and convexities.

The light(s) scattered and/or diffracted by such a concave-convex pattern is (are) a light having a wavelength in a relatively broad band, rather than a light having a single wavelength or a light having a wavelength in a narrow band, and the scattered and/or diffracted light(s) have no directivity, and travel(s) in various directions. Note that, however, the term "irregular concave-convex pattern" includes such a quasi-periodic structure in which a Fourier-transformed image, obtained by performing a two-dimensional fast Fourier-transform processing on a concavity and convexity analysis image obtained by analyzing a concave-convex shape on the surface, shows a circular or annular pattern, namely, such a quasi-periodic pattern in which, although the concavities and convexities have no particular orientation (directionality), the structure has the distribution of the pitches of concavities and convexities (the pitches of the concavities and convexities vary). Therefore, the substrate having such a quasi-periodic structure is suitable for a diffraction substrate used in a surface-emitting element etc., such as the organic EL element, a transparent conductive substrate of a solar cell, and the like, provided that the substrate has the concavities and convexities of which pitch distribution or pitch variability enables the substrate to diffract visible light.

As the coating method of the second sol-gel material, it is possible to use any coating method including, for example, a bar coating method, a spin coating method, a spray coating method, a dip coating method, a die coating method, and an ink-jet method. Among these methods, the bar coating method, the die coating method, and the spin coating method are preferable since the bar coating method, the die coating method, and the spin coating method are capable of uniformly coating the substrate having a relatively large area with the second sol-gel material, and are capable of quickly completing the coating before the second sol-gel material is cured (gelated).

### <Curing step>

After the substrate is coated with the second sol-gel material (concave-convex coating material), the sol-gel material layer (concave-convex structure layer) 42 (see Fig. 4) is subjected to baking (step S7 of Fig. 1). The sol-gel material layer 42 is formed of the island structure 54, which is made of the first sol-gel material (concave-convex forming material) and formed on the substrate, and the coating film 62 made of the second sol-gel material. The hydroxyl group and the like contained in the sol-gel material layer 42 is desorbed or eliminated by the baking to further harden (solidify) the coating film. It is preferred that the baking be performed at a temperature in a range of 200 degrees Celsius to 1,200 degrees Celsius for a duration of time in a range of about 5 minutes to about 6 hours. In such a manner, the sol-gel material layer 42 is cured, and a sol-gel structure (diffraction grating) with the wave-like structure, which includes convexities corresponding to the convexities of the island structure 54 made of the first sol-gel material, is obtained. In this situation, the sol-gel material layer 42 is amorphous, crystalline, or in a mixture state of the amorphous and the crystalline, depending on the baking temperature and baking time. When the photo-curable sol-gel material is used as the first sol-gel material and/or the second sol-gel material, the sol-gel material layer 42 may turn into a gel (be cured) by being irradiated with light, instead of being subjected to heating and baking.

By forming the island structure 54 on the substrate 40 by means of the micro contact printing and subsequently forming the coating film 62 made of the second sol-gel material as described above, the optical substrate 100 including the sol-gel material layer 42 with the wave-like structure is obtained. The optical substrate 100 can be used as, for example, a diffraction-grating substrate for organic EL element, a wire grid polarizer, an antireflection film, or an optical element for providing the light confinement effect in a solar cell by being placed on the photoelectric conversion surface side of the solar cell. Alternatively, the substrate having the above-described pattern may be used as a mold (mother die) so as to transfer the pattern to yet another resin. In this case, the transferred resin pattern is an inverted pattern of the pattern on the substrate. Thus, it is allowable to produce a mold as a replica of the substrate by transferring the transferred inverted pattern to yet another resin. Each of the molds can be subjected to an electroforming process using Ni, etc. so as to form a metallic mold. By using each of these molds, it is possible to mass-produce an optical part or component, such as the diffraction-grating substrate for organic EL element, more efficiently. In the above embodiment, the first sol-gel material and the second sol-gel material are used to form the island structure 54 and the coating film 62, respectively. Instead of using the sol-gel materials, metal oxides can be used. The same is true on the method for producing the organic EL element described below.

### <Method for producing organic EL element>

An explanation will be made with reference to Fig. 5 about an exemplary production method for producing an organic EL element by use of the substrate on which the wave-like structure made of the sol-gel materials is formed. At first, a substrate having the pattern made of the sol-gel material layer formed thereon is cleaned with a brush in order to remove foreign matters and the like adhered to the substrate, and then an organic matter, etc. is removed with an alkaline cleaning agent and an organic solvent. Next, as depicted in Fig. 5, a transparent electrode 92 is stacked on the sol-gel material layer 42 on the substrate 40 so as to maintain the concave-convex structure formed on the surface of the sol-gel material layer 42. Examples of those usable as the material for the transparent electrode 92 include indium oxide, zinc oxide, tin oxide, indium-tin oxide (ITO) which is a composite material thereof; gold; platinum, silver; copper, etc. Among these materials, ITO is preferable from the viewpoint of the transparency and the electrical conductivity. The thickness of the transparent electrode 92 is preferably within a range of 20 nm to 500 nm. When the thickness is less than the lower limit, the electrical conductivity is more likely to be insufficient. When the thickness exceeds the upper limit, there is possibility that the transparency is so insufficient that the emitted EL light cannot be extracted to the outside sufficiently. As the method for stacking the transparent electrode 92, it is possible to appropriately use any known method such as the evaporation method, sputtering method, spin coating method, etc. Among these methods, the sputtering method is preferably employed from the viewpoint of improving the adhesion property. Afterwards, the transparent electrode 92 is coated with photoresist, followed by being exposed with an electrode mask pattern. Then, etching is performed with a developing solution, thereby obtaining a transparent electrode having a predetermined pattern. Note that during the sputtering, the substrate is exposed to a high temperature of about 300 degrees Celsius. After cleaning the obtained transparent electrode with a brush and removing any organic matter, etc., with an alkaline cleaning agent and an organic solvent, a UV ozone treatment is preferably performed.

Next, an organic layer 94 as depicted in Fig. 5 is stacked on the transparent electrode 92. The organic layer 94 is not particularly limited, provided that the organic layer 94 is one usable as an organic layer of the organic EL element. As the organic layer 94, any known organic layer can be used as appropriate. Further, the organic layer 94 may be a stacked body of various organic thin films, and may be, for example, a stacked body of a hole transporting layer 95, a light emitting layer 96, and an electron transporting layer 97 as depicted in Fig. 5. Here, examples of the material of the hole transporting layer 95 include aromatic diamine compounds such as phthalocyanine derivatives, naphthalocyanine derivatives, porphyrin derivatives, N,N'-bis(3-methylphenyl)-(1,1'-biphenyl)-4,4'-diamine (TPD), and 4,4'-bis[N-(naphthyl)-N-phenyl-amino]biphenyl(α-NPD); oxazole; oxadiazole; triazole; imidazole; imidazolone; stilbene derivatives; pyrazoline derivatives; tetrahydroimidazole; polyarylalkane; butadiene; and 4,4',4"-tris(N-(3-methylphenyl)N-phenylamino) triphenylamine (m-MTDATA). The material of the hole transporting layer 95, however, is not limited to these.

Further, the light emitting layer 96 is provided so that a hole injected from the transparent electrode 92 and an electron injected from a metal electrode 98 are recombined to emit light. Examples of the material usable as the light emitting layer 96 include: metallo-organic complex such as anthracene, naphthalene, pyrene, tetracene, coronene, perylene, phthaloperylene, naphthaloperylene, diphenylbutadiene, tetraphenylbutadiene, coumarin, oxadiazole, bisbenzoxazoline, bisstyryl, cyclopentadiene, and aluminum-quinolinol complex (Alq3); tri-(p-terphenyl-4-yl)amine; 1-aryl-2,5-di(2-thienyl) pyrrole derivatives; pyran; quinacridone; rubren; distyrylbenzene derivatives; distyryl arylene derivatives; distyryl amine derivatives; and various fluorescent pigments or dyes. Furthermore, it is preferable that light-emitting materials selected from the above compounds are mixed as appropriate and then are used. Moreover, it is possible to suitably use a material system generating emission of light from a spin multiplet, such as a phosphorescence emitting material generating emission of phosphorescence, and a compound including, in a part of the molecules, a constituent portion formed by the above materials. Note that the phosphorescence emitting material preferably includes heavy metal such as iridium. A host material having high carrier mobility may be doped with each of the light-emitting materials as a guest material to generate the light emission using the dipole-dipole interaction (Foerster mechanism) or electron exchange interaction (Dexter mechanism). Examples of the material of the electron transporting layer 97 include heterocyclic tetracarboxylic anhydrides such as nitro-substituted fluorene derivatives, diphenylquinone derivatives, thiopyran dioxide derivatives, and naphthaleneperylene; and organometallic complex such as carbodiimide, fluorenylidene methane derivatives, anthraquino dimethane and anthrone derivatives, oxadiazole derivatives, and aluminum-quinolinol complex (Alq3). Further, in the above-described oxadiazole derivatives, it is also possible to use, as an electron transporting material, thiadiazole derivatives in which oxygen atoms of oxadiazole rings are substituted by sulfur atoms and quinoxaline derivatives having quinoxaline rings known as electron attractive group. Furthermore, it is also possible to use a polymeric material in which the above materials are introduced into a macromolecular chain or the above materials are made to be a main chain of the macromolecular chain. Note that the hole transporting layer 95 or the electron transporting layer 97 may also function as the light-emitting layer 96. In this case, the organic layer between the transparent electrode 92 and the metal electrode 98 is double-layered.

From the viewpoint of facilitating the electron injection from the metal electrode 98, a layer made of a metal fluoride or metal oxide such as lithium fluoride (LiF) or Li₂O₃, a highly active alkaline earth metal such as Ca, Ba, or Cs, an organic insulating material, or the like may be provided as an electron injection layer between the organic layer 94 and the metal electrode 98. Further, from the viewpoint of facilitating the hole injection from the transparent electrode 92, it is allowable to provide, as a hole injection layer between the organic layer 94 and the transparent electrode 92, a layer made of triazol derivatives, oxadiazole derivative, imidazole derivative, polyarylalkane derivatives, pyrazoline and pyrazolone derivatives, phenylenediamine derivative, arylamine derivatives, amino-substituted calcone derivatives, oxazole derivatives, styrylanthracene derivatives, fluorenone derivatives, hydrazone derivatives, stilbene derivatives, silazane derivatives, aniline-based copolymers, or electroconductive high-molecular oligomar, particularly thiophene oligomer.

Furthermore, when the organic layer 94 is a stacked body formed of the hole transporting layer 95, the light emitting layer 96 and the electron transporting layer 97, the thicknesses of the hole transporting layer 95, the light emitting layer 96 and the electron transporting layer 97 are preferably within a range of 1 nm to 200 nm, a range of 5 nm to 100 nm, and a range of 5 nm to 200 nm, respectively. As the method for stacking the organic layer 94, any known method such as the vapor deposition method, sputtering method, spin coating method and die coating method can be employed as appropriate.

In the step for forming the organic EL element, subsequently, a metal electrode 98 is stacked on the organic layer 94, as depicted in Fig. 5. Materials of the metal electrode 98 are not particularly limited, and a substance having a small work function can be used as appropriate. Examples of the materials include aluminum, MgAg, MgIn, and AlLi. The thickness of the metal electrode 98 is preferably within a range of 50 nm to 500 nm. When the thickness is less than the lower limit, the electrical conductivity is more likely to be decreased. When the thickness exceeds the upper limit, there is such a possibility that the repair might be difficult to perform when any short circuit occurs between the electrodes. Any known method such as the vapor deposition method, sputtering method, etc. can be adopted to stack the metal electrode 98. Accordingly, an organic EL element 200 having a structure as depicted in Fig. 5 can be obtained.

In the above embodiment, the sol-gel material layer (concave-convex structure layer) 42, which is formed of the island structure 54 made of the first sol-gel material and the coating film 62 made of the second sol-gel material, may have the wave-like structure (concave-convex structure) having convexities which are formed on portions corresponding to portions of the convexities of the island structure 54 made of the first sol-gel material. As described above, when the concave-convex pattern of the optical substrate produced in accordance with the method of present invention is made of the metal oxide such as the sol-gel material, this optical substrate is advantageous in the following points as compared with a substrate having a concave-convex pattern made of a curable resin. Namely, since the metal oxide such as the sol-gel material has excellent mechanical strength, any flaw or scratch, adhesion of any foreign matter, generation of any projected portion on the transparent electrode during the production process of the organic EL element are less likely to occur, even when the cleaning with a brush is performed for the surface formed with the concave-convex pattern after the formation of the substrate and the transparent electrode, thereby making it possible to prevent any failure of the element which would be otherwise caused by the flaw, foreign matter, projected portion, etc. Therefore, the organic EL element obtained by the method of the present invention is more superior to that obtained by using the substrate made of the curable resin, in view of the mechanical strength of the substrate having the concave-convex pattern.

The substrate, which is produced in accordance with the method of the present invention by use of the metal oxide such as the sol-gel material, has excellent chemical resistance, and thus has a relatively high corrosion resistance against the alkaline solution, the organic solvent, etc. used in the cleaning step of the substrate and the transparent electrode, thereby making it possible to use a variety of kinds of cleaning solutions. Further, the alkaline developing solution is used during the patterning of the transparent substrate in some cases as described above, and the substrate formed by use of the metal oxide such as the sol-gel material has also chemical resistance against such a developing solution. In this respect, the substrate formed by use of the metal oxide such as sol-gel material is advantageous as compared with the substrate formed by use of the curable resin of which chemical resistance to the alkaline solution is relatively low.

The substrate, which is produced in accordance with the method of the present invention by use of the metal oxide such as the sol-gel material, has excellent heat resistance. Therefore, the substrate formed by use of the metal oxide such as the sol-gel material can withstand a high temperature environment of the sputtering step in the process of forming the transparent electrode for the organic EL element. Further, the substrate, which is produced in accordance with the method of the present invention by use of the metal oxide such as the sol-gel material, has UV resistance and weather resistance superior to those of the substrate made of the curable resin, and thus also has the resistance against the UV ozone cleaning treatment performed after the formation of transparent electrode.

When the organic EL element produced by the above embodiment is used outdoors, any degradation due to the sunlight can be prevented more than when an organic EL element produced by using the substrate having the concave-convex pattern formed in the curable resin is used. Further, any long term use of the organic EL element using the resin substrate is difficult because the curable resin as described above might be degraded to generate any yellowing, any gas, etc. when the curable resin is left under a high temperature environment for a long period of time due to the heat generation associated with the light emission. In contrast, such degradation is prevented in the organic EL element provided with the substrate formed by use of the metal oxide such as the sol-gel material.

Although the present invention has been explained as above with the embodiment, the method for producing the member having the concave-convex structure, such as the optical substrate having the concave-convex pattern, of the present invention, are not limited to the above-described embodiment, and may be appropriately modified or changed within the range of the technical ideas described in the following claims. The method for producing the member having the concave-convex structure in accordance with the present invention is not limited to the production of the optical substrate, and can be used for various uses including, for example, the production of optical elements such as microlens arrays, prism arrays, and optical waveguides; the production of optical components such as lenses; the production of LED; the production of solar cells; the production of antireflection films; the production of semiconductor chips; the production of patterned media; the production of data storage; the production of electronic paper; the production of LSI; paper manufacturing; food manufacturing; and the biology field such as immunoassay chips and cell culture sheets. It is possible to use various materials as the concave-convex forming material and the concave-convex coating material depending on the way of use. For example, in cases of producing optical elements, optical components, solar cells, antireflection films, semiconductor chips, patterned media, data storage, electronic paper, LSI, and the like, it is possible to use photoreactive (photocurable) resins, thermoreactive (thermosetting) resins, polymeric resins, metal oxides such as the sol-gel material, organic-inorganic hybrid materials, etc. Further, fibrous materials, particulate (spherical) materials, and flaky or flake-like materials can be added to the above materials. The material to be added is exemplified, for example, by organic compounds (low-molecular compounds, high-molecular compounds), inorganic compounds (carbon materials, silicon materials, metals, metal oxides, etc.), and organic-inorganic hybrid materials. The material to be added is not limited to those. Further, pulp and the like can be used as the coating material in the paper manufacturing, and a variety of food materials can be used as the coating material in the food manufacturing. Further, the concave-convex pattern of the member produced in accordance with the production method of the present invention is not limited to the irregular concave-convex pattern obtained by the BCP or BKL method, and may be a regular concave-convex pattern. The concave-convex pattern of the member produced in accordance with the production method of the present invention may be a line pattern or a dot pattern. The concave-convex structure is not limited to the wave-like structure, and may be a rectangular structure, a V-shaped structure, a random structure, or the like.

### Industrial Applicability

The method for producing the member having the concave-convex structure in accordance with the present invention is capable of producing the member having the concave-convex structure with high throughput while forming the minute pattern accurately and reliably. The concave-convex pattern of the member having the concave-convex structure produced by the production method in accordance with the present invention is excellent in the heat resistance, weather resistance, and corrosion resistance. Further, the concave-convex pattern is also resistant to the process for manufacturing an element (device) in which the member having the concave-convex structure is incorporated, which makes it possible to extend the service life of the element. Therefore, the member having the concave-convex structure obtained by the production method of the present invention is quite effective for various devices such as the organic EL elements and the solar cells. The various devices, such as the organic EL elements and the solar cells, which are excellent in the heat resistance, weather resistance, and corrosion resistance can be produced by using, as the optical substrate, the member having concave-convex structure obtained in this manner. Further, the use of the production method of the present invention is not limited to the production of the optical substrate, and the production method of the present invention can be used in various uses. For example, the production method of the present invention can be used, for example, for the production of light condensing or focusing films and antireflection films for solar cells and various displays; the production of semiconductor chips and the like; paper manufacturing such as the production of tissues (for example, drums used for compressing webs); food manufacturing such as noodle making; and the production in the biologic field such as bio chips including fine or minute channels, bio chips for analyzing genome and proteomoe, cell culture sheets (nanopillar sheets used as cell culture containers), and microchips for cell fractionation or cell separation.

### Reference Signs List:

38: master mold; 40: substrate; 42: sol-gel material layer; 52: coating film made of first sol-gel material; 62: coating film made of second sol-gel material; 83: stamp; 92: transparent electrode; 94: organic layer; 95: hole transporting layer; 96: light-emitting layer; 97: electron transporting layer; 98: metal electrode; 200: organic EL element

## Claims

1. A method for producing a member having a concave-convex structure, comprising:
a step of preparing a stamp having a concave-convex pattern;
a step of coating a convex of the stamp with a concave-convex forming material;
a step of transferring the concave-convex forming material to a substrate by bringing the substrate into contact with the stamp coated with the concave-convex forming material; and
a step of coating the substrate with a concave-convex coating material so that the concave-convex coating material covers the concave-convex forming material transferred to the substrate.

2. The method for producing the member having the concave-convex structure according to claim 1, wherein the substrate is coated with the concave-convex coating material to form, on the substrate, a concave-convex structure layer made of the concave-convex forming material and the concave-convex coating material.

3. The method for producing the member having the concave-convex structure according to claim 1 or 2, wherein the concave-convex forming material is a sol-gel material.

4. The method for producing the member having the concave-convex structure according to any one of claims 1 to 3, wherein the concave-convex coating material is a sol-gel material.

5. The method for producing the member having the concave-convex structure according to any one of claims 1 to 4, wherein the concave-convex forming material is transferred to form an island structure on the substrate.

6. The method for producing the member having the concave-convex structure according to claim 5, wherein the substrate is coated with the concave-convex coating material so that a part of the concave-convex coating material makes contact with the substrate.

7. The method for producing the member having the concave-convex structure according to any one of claims 1 to 6, wherein the member having the concave-convex structure is an optical substrate.

8. The method for producing the member having the concave-convex structure according to any one of claims 1 to 7, wherein the stamp is made of silicone rubber.

9. The method for producing the member having the concave-convex structure according to any one of claims 1 to 8, wherein the concave-convex forming material has viscosity higher than that of the concave-convex coating material.

10. The method for producing the member having the concave-convex structure according to any one of claims 1 to 9, wherein the concave-convex forming material is heated in the step of transferring the concave-convex forming material to the substrate.

11. The method for producing the member having the concave-convex structure according to claim 10, wherein the concave-convex forming material is heated to a temperature in a range of 150 to 200 degrees Celsius.

12. The method for producing the member having the concave-convex structure according to any one of claims 1 to 11, wherein a height of the concave-convex forming material transferred on the substrate is adjusted by adjusting solid content concentration of the concave-convex forming material.

13. The method for producing the member having the concave-convex structure according to any one of claims 1 to 12, wherein a film thickness of the concave-convex coating material, with which the substrate is coated, is adjusted by adjusting solid content concentration of the concave-convex coating material.

14. A member having a concave-convex structure on a substrate produced by the method for producing the member having the concave-convex structure as defined in any one of claims 1 to 13.

15. A method for producing an organic light emitting diode, comprising producing the organic light emitting diode by use of the member having the concave-convex structure as defined in claim 14.

16. An optical member having a concave-convex structure, comprising:
a substrate;
an island structure including convexities, which are made of a material different from that of the substrate and are formed on a surface of the substrate to be isolated from one another; and
a coating part which covers the island structure and a substrate surface which is exposed between the convexities of the island structure.

17. The optical member according to claim 16, wherein both of the convexities and the coating part are made of a sol-gel material.

18. The optical member according to claim 16, wherein a material of the convexities is different from that of the coating part.

19. The optical member according to any one of claims 16 to 18, wherein the optical member is a light extraction substrate for an organic light emitting diode.
